# EUROPEAN PATENT APPLICATION

(11) **EP 2 680 544 A1**
(43) Date of publication of application: **01.01.2014**
(21) Application number: 12748962.3
(22) Date of filing: 22.02.2012
(51) Int. Cl.: H04M 1/02, G02F 1/1333, G09F 9/00, H05K 5/02

(54) **MOBILE ELECTRONIC DEVICE**

(30) Priority: 23.02.2011 JP 2011036528
(71) Applicant: NEC CASIO Mobile Communications, Ltd., Kawasaki-shi Kanagawa 211-8666 (JP); NTT DOCOMO, INC., Chiyoda-ku Tokyo 100-6150 (JP)
(72) Inventor: SATO, Junya, Kawasaki-shi, Kanagawa 211-8666 (JP); KOMIYAMA, Takehiko, Kawasaki-shi, Kanagawa 211-8666 (JP); SHIMOBAYASHI, Tokio, Kakegawa-shi, Shizuoka 436-8501 (JP); YANO, Eiji, Tokyo 100-6150 (JP); NAGATA, Ryuuji, Tokyo 100-6150 (JP); SUGISAKI, Haruhiko, Tokyo 100-6150 (JP)
(74) Representative: Vossius & Partner
(86) International application number: PCT/JP2012/054313
(87) International publication number: WO 2012/115164

(57) **Abstract**

The present invention is relates to a mobile electronic apparatus including a packaging structure configured to evade destruction of a display part against an impact applied from outside. In a mobile electronic apparatus (1), if an impact is applied from a direction (B), a casing composed by a casing section (51), a bottom cover (20) and a cover (60) become deformed. If the casing is deformed, a hollow section (100) is deformed at the same time. A key rubber (30) becomes deformed to follow the portions becoming deformed. By the key rubber (30) becoming deformed, the impact applied from outside may be absorbed, and impact exerted to LCD module is reduced.

## Description

### TECHNICAL FIELD

### (CROSS-REFERENCE TO RELATED APPLICATION)

This application is based upon and claims the benefit of the priority of Japanese patent application No. 2011-036528 filed on February 23, 2011, the disclosure of which is incorporated herein in its entirety by reference thereto.
This invention relates to a mobile electronic apparatus and, more particularly, to a packaging structure thereof that will evade destruction of a display part against the shock exerted from outside.

### BACKGROUND ART

Recently, mobile electronic apparatuses, such as cellular phone, smartphones, PDAs (Personal Digital Assistants), digital cameras, music players or game machines have come into widespread use. These mobile electronic apparatuses are becoming diversified in their functions at a rapid pace, such that it is necessary that a number of functional modules, configured for coping with the widely diversified functions, are enclosed within the main body part of the apparatus. On the other hand, an LCD (Liquid Crystal Display), equipped on the mobile electronic apparatuses to make still or moving pictures look more beautiful, tends to be of finer definition and of a larger picture size format.

Since the mobile electronic apparatus are carried about by the users, it may sometimes occur that the users drop them inadvertently. It is however a requirement that, even if a strong shock is applied to the mobile electronic apparatus from outside, modules, such as LD modules, are not fractured.

Patent Literature 1 shows a technique in which a metallic frame is provided within a casing to increase its rigidity so the shock from outside will not be directly imparted to inner components such as LCD or substrate. As a result, it is possible to protect the LCD or the like arranged within the casing of the mobile electronic apparatus.

Patent Literatures 2 through to 4 show a technique which takes advantage of a void spacing provided within a casing in order to moderate the shock that may be exerted from outside.

### CITATION LIST

### PATENT LITERATURE

[PTL 1]
   JP Patent Kokai Publication No. JP2007-110322A
[PTL 2]
   JP Patent Kokai Publication No. JP2000-069135A
[PTL 3]
   JP Patent Kokai Publication No. JP2000-316041A
[PTL 4]
   JP Patent Kokai Publication No. JP2010-238224A

### SUMMARY

### TECHNICAL PROBLEM

The total of the contents disclosed in the citations is to be incorporated by reference herein. The following analysis has been made from the perspective of the present invention.

The mobile electronic apparatuses are becoming advanced in their functions, whilst display picture surfaces thereof are becoming larger in the picture size format. On the other hand, the mobile electronic apparatuses per se are becoming smaller in size as well as in weight. It is because the mobile electronic apparatuses are carried about during use which accounts for the reason that their size and weight are decreased. Since the function amelioration and the picture image size enhancement proceed at the same time as reduction in size and weight of the mobile electronic apparatuses, the relative space the casing occupies in the mobile electronic apparatus in its entirety tends to be decreased. Thus, even if the technique disclosed in Patent Literature 1 is used, sufficient casing rigidity may not be acquired since the area as well as the capacity of the casing per se is decreased. As a result, the probability is high that, in case the mobile electronic apparatuses are inadvertently dropped, the LCDs, as an example, are fractured.

The conventional technique suffers from problems that are to be solved, as discussed above.

In a phase of the present invention, such mobile electronic apparatus, having a packaging structure that protects its display part from a force of impact exerted from outside, is a desideratum.

### SOLUTION TO PROBLEM

In a first aspect, the present invention, there is provided a mobile electronic apparatus comprising a casing having an open part in a first surface thereof, an elastic member arranged in the open part, and a display part disposed adjacent to a second surface of the casing. The casing and the elastic member together delimit a hollow section. In case an impact is applied to a third surface opposite to the second surface, the elastic member becomes deformed to follow deformation of the hollow section.

### ADVANTAGEOUS EFFECTS OF INVENTION

In the above mentioned first aspect of the present invention, a mobile electronic apparatus may be provided which is provided with a packaging structure that protects a display part from a shock applied from outside.

### BRIEF DESCRIPTION OF THE DRAWINGS

Fig.1 is a schematic view illustrating an outline of an exemplary embodiment.
Fig.2 is a perspective view showing an example overall appearance of the mobile electronic apparatus according to exemplary embodiment 1.
Fig.3 is a cross-sectional view of the mobile electronic apparatus taken along arrows A-A in Fig.2.
Fig.4 is a plan view showing an example of casings 50, 51 of Fig.3.
Fig.5 is a cross-sectional view of the mobile electronic apparatus, taken along arrows A-A, showing the state of the apparatus when a force of impact is applied thereto from a direction B.
Fig.6 is a cross-sectional view showing an example case where there lack a part of a key rubber and a flexible substrate shown in the cross-sectional view of Fig.3.

### MODES FOR CARRYING OUT THE INVENTION

Initially, schematics of an exemplary embodiment will be described with reference to the drawings. It is noted that symbols for referring to the drawings are attached to the respective elements merely as examples to assist in the understanding and are not intended to limit the present invention to the illustrated modes.

In the mobile electronic apparatus, in which the function amelioration and the picture image size enhancement proceed at the same time as reduction in size and weight of the apparatus, it is becoming difficult to secure sufficient rigidity of the casing. As a result, the probability is high that an LCD, for example, is fractured in case the apparatus is inadvertently dropped. It is therefore desirable that the mobile electronic apparatus has a packaging structure that protects the display part from the shock applied from outside.

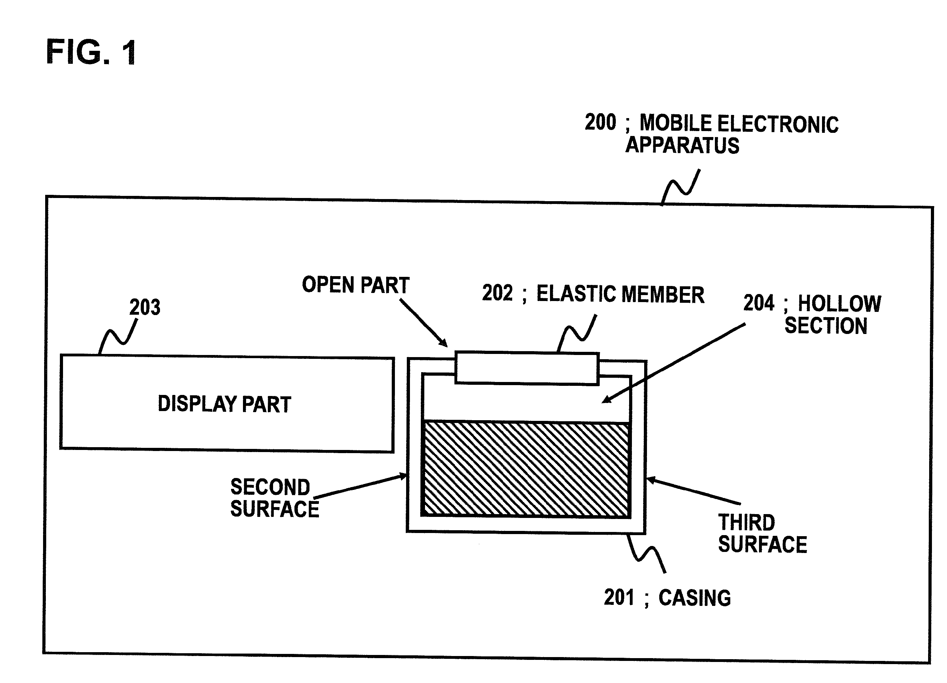

The present disclosure thus proposes a mobile electronic apparatus 200 having a packaging structure shown in Fig.1. The mobile electronic apparatus 200, shown in Fig.1, includes a casing 201, having an open part in its first surface, an elastic member 202 mounted in the open part, and a display part 203 disposed adjacent to a second surface of the casing 201. A hollow section 204 is delimited on putting together the casing 201 and the elastic member 202. The hollow section 204 is a void spacing delimited within the casing including the open part 201 by the casing and by the elastic member 202. The hollow section provides a space allowance for the casing 201 to become deformed in case a force of impact is applied to the casing 201. Hence, the hollow section 204 may comprise a component(s) that is flexibly changed in shape to permit the casing 201 to be deformed when a force of impact is applied to the casing 201 from outside.

In case a force of impact is applied from outside to a third surface of the mobile electronic apparatus 200 shown in Fig.1, the hollow section 204 becomes deformed at the same time as the casing 201 becomes deformed. The elastic member 202 becomes deformed to follow the hollow section 204 becoming deformed, so as to alleviate the force of impact. Hence, the force of impact applied to the third surface is not transmitted to the display part 203, located adjacent to the second surface, thus protecting the display part 203.

The following modes are possible with the present invention.

### [Mode 1]

The mode is the same as the mobile electronic apparatus according to the first aspect.

### [Mode 2]

Preferably, the elastic member includes a protuberance contacted with a circuit configured to transform a user actuation into an electrical signal. The protuberance is disposed within the hollow section.

### [Mode 3]

Preferably, the circuit is mounted on a substrate which is resilient and deformable, and the circuit is disposed within the hollow section.

### [Mode 4]

Preferably, the third surface of the casing has a raised center portion.

### [Mode 5]

Preferably, the display part includes a screen or a substrate on which to display a picture image.

### [Mode 6]

Preferably, the display part is an LCD module.

### [Exemplary embodiment 1]

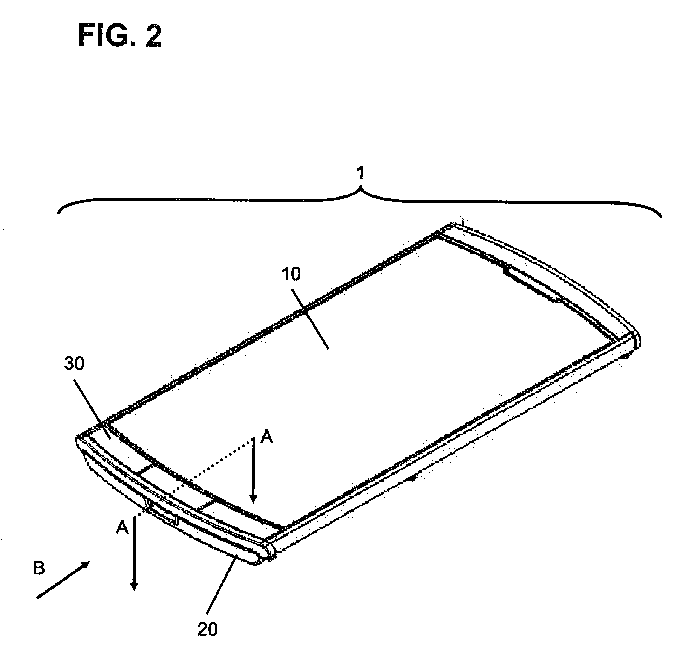

An exemplary embodiment 1 will now be described in detail with reference to the drawings. Fig.2 depicts a perspective view showing an example overall appearance of a mobile electronic apparatus 1 according to the exemplary embodiment 1. In the mobile electronic apparatus 1 of the present exemplary embodiment, it is assumed that a main body part and a display part are combined together to form a single unit. However, such is only for explanation sake and is not intended to limit the present disclosure to the mode shown. For example, the mobile electronic apparatus 1 may be of a collapsible type or a rotative bi-axial hinged type.

The mobile electronic apparatus 1 includes a screen 10, on which to display a picture image, a bottom cover 20 and a key rubber 30 accepting key actuation. This key rubber is equivalent to the above mentioned elastic component 202.

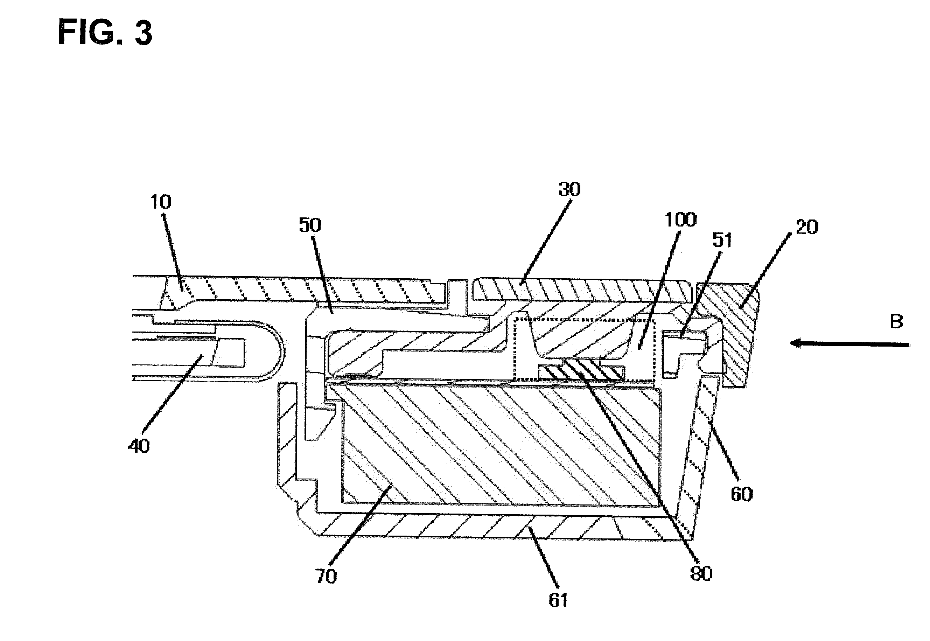

Fig.3 is a cross-sectional view taken in a direction as shown by arrows A, A to show components around the key rubber 30 of the mobile electronic apparatus 1 shown in Fig.2. The cross-sectional view of Fig.3 illustrates a screen 10, a bottom cover 20, a key rubber 30, an LCD module 40, casing sections 50, 51, cover sections 60, 61, a basement 70 and a flexible substrate 80.

The LCD module 40 is a display module including an LCD, and is equivalent to the above mentioned display part 203. The casing sections 50, 51 compose a casing of the mobile electronic apparatus 1. The basement 70 sustains a load exerted on key actuation. The flexible substrate 80 includes a circuit that transforms actuations performed by a user via the key rubber 30 into an electrical signal.

If, in the mobile electronic apparatus 1, the screen 10, bottom cover 20, key rubber 30, LCD module 40, casing sections 50, 51, cover sections 60, 61, basement 70 and the flexible substrate 80 are put together, there is defined an area made up of a void spacing and soft components. In Fig.3, a zone that is delimited by a broken line corresponds to such area, and which is herein termed a hollow section 100. The hollow section 100 includes a protuberance of the key rubber 30 and the flexible substrate 80. Note that Fig.3 shows a state of the mobile electronic apparatus 1 in which an impact is not exerted thereto from outside.

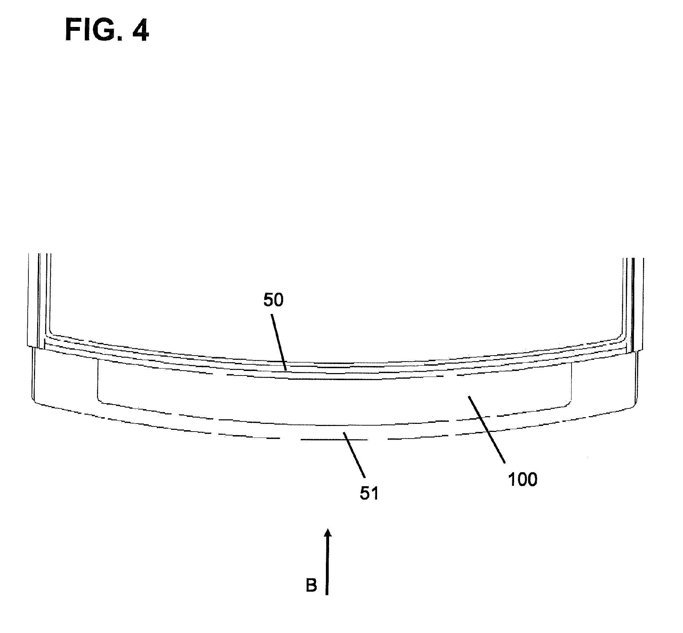

Fig.4 depicts a plan view showing the casing sections 50, 51. The key rubber 30 is mounted in the hollow section 100 shown in Fig.4. The casing section 51 is arched in shape. However, the casing section 51 need not be arched in shape, such that it may also be protuberant at its mid portion, for example, it may be frusto-conical in shape.

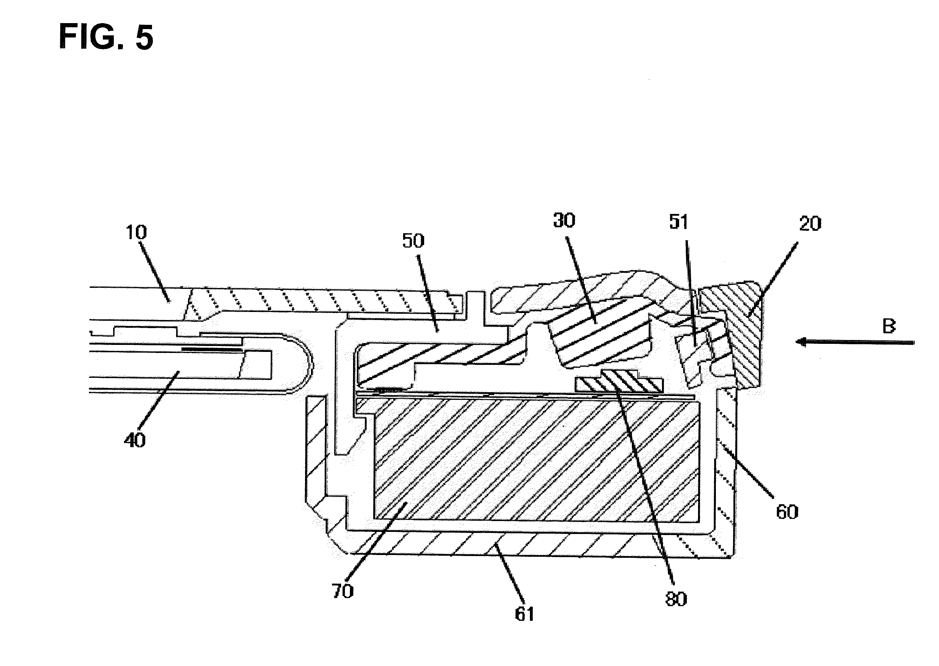

It is now supposed that a force of impact is applied to the mobile electronic apparatus 1 of the above described configuration from a direction B in Fig.2, Fig.3. The mobile electronic apparatus 1, shown in Fig.2, is shown in Fig.5, a cross-sectional view taken along the direction indicated by arrows A, A, in a state in which a force of impact has been applied to the apparatus from the direction B.

When the force of impact is applied to the mobile electronic apparatus 1 from the direction shown by arrow B, the bottom cover 20, key rubber 30, casing section 51 and the cover section 60 are deformed. In more concrete terms, if the force of impact is applied to the mobile electronic apparatus 1 from the direction B, the casing composed by such members as the casing section 51, bottom cover 20 and the cover section 60 becomes deformed, as shown in Fig.5. If the casing is deformed, the hollow section 100 is deformed at the same time. The key rubber 30 is deformed so as to follow these parts which are becoming deformed. The key rubber, thus deformed, absorbs the shock applied from outside, such as to moderate the force of impact applied to the LCD module 40.

Thus, even in case of descent of the mobile electronic apparatus 1, it is possible to evade fracture of the LCD module 40. In addition, if a force of impact is applied to the casing section 51 from the direction of arrow B in Fig.4, the casing section 51, inherently arched in shape, becomes deformed to a linear shape.

In the present exemplary embodiment, it is assumed that a subject to be protected in case the force of impact is applied from outside the mobile electronic apparatus 1 is the LCD module 40. However, this is merely illustrative. For example, the subject to be protected may also be a component vulnerable against impact, such as the screen 10 or the substrate. The shape of the component parts, inclusive of the casing sections 50, 51 or the cover section 60, is not be limited to that shown in the present exemplary embodiment. Or, the flexible substrate 80 may also be a rigid- flexible substrate obtained by depositing an ACF (anisotropic conductive film) on a rigid substrate to unify the so deposited film to the rigid substrate.

As described above, the hollow section 100 is provided within the inside of the mobile electronic apparatus 1. The casing (bottom cover 20, casing section 51 and cover section 60) as well as the hollow section 100 becomes deformed under the force of impact applied from outside the mobile electronic apparatus 1. As the hollow section 100 becomes deformed, the key rubber 30 becomes deformed, as a result of which the force of impact acting on the LCD module 40 may be moderated to prevent the LCD module from being fractured. Moreover, a flexible member, such as a rubber component, which is soft and flaccid, is arranged within the hollow section 100, such that component parts as needed for configuring the mobile electronic apparatus 1 are arranged as the room for the flexible member to become deformed is left in the hollow section 100. This improves the packaging efficiency of the mobile electronic apparatus 1. Hence, the mobile electronic apparatus may further be reduced in size, thickness and weight.

In addition, a metallic frame, used in the technique disclosed in Patent Literature 1 to improve rigidity of the casing sections, is now unnecessary, whilst the casing does not have to be increased in size to maintain the rigidity of the casing sections. It is unnecessary to add reinforcement parts to improve rigidity of the component parts or shock-absorbing components, thus enabling the number of the component parts of the mobile electronic apparatus 1 to be reduced. As a result, only a smaller quantity of a resin material suffices in fabricating the casing, thus contributing to reduced weight and costs of the mobile electronic apparatus.

### [Exemplary embodiment 2]

An exemplary embodiment 2 will now be described in detail with reference to the drawings. In the exemplary embodiment 1, the mobile electronic apparatus has a key on its display surface. In the present exemplary embodiment, it is not strictly necessary that there is a key on the display surface.

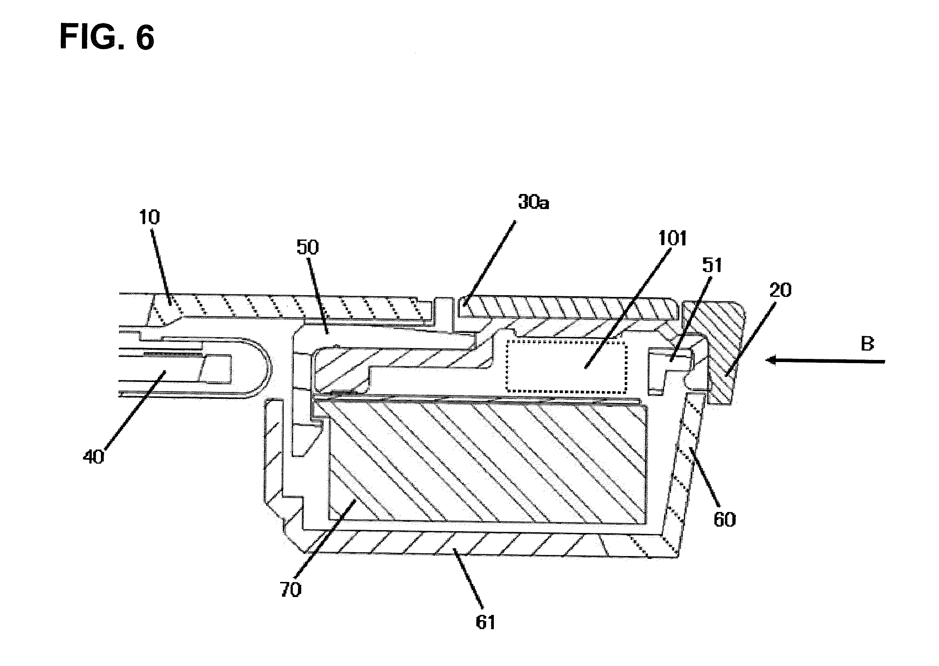

Fig.6 depicts a cross-sectional view showing an example case where parts of the key rubber 30 and the flexible substrate 80, such as those shown in the cross-sectional view of Fig.3, are lacking. In Fig.6, the same symbols are used to denote component parts which are the same as those shown in Fig.3, and the corresponding explanation is dispensed with

In the exemplary embodiment 1, the hollow section 100 is composed by a void spacing and flexible components. Alternatively, a hollow section 101 may be composed by solely a void spacing. Even in such case, the bottom cover 20, a key rubber 30a, a casing section 51 and a cover section 60 become deformed to prevent the LCD module 40 from being fractured by impact applied from outside.

In the present exemplary embodiment, it is assumed that the key rubber corresponds to the key rubber 30 a part of which has been removed. Since there is no key on the display surface of a mobile electronic apparatus 2 of the present exemplary embodiment, it is an elastic member shaped equivalently to the key rubber 30a that is actually used.

The disclosures of the Patent Literatures are to be incorporated herein by reference. The particular exemplary embodiments may be modified or improved within the gamut of the entire disclosure of the present invention, inclusive of claims, based on the fundamental technical concept of the invention. Moreover, variegated combinations, substitutions or selections of the elements disclosed inclusive of various elements of the claims, exemplary embodiments or the drawings may be made within the context of the claims. Viz., as a matter of course, the present invention may comprise a variety of modification or adjustments that may readily be made by those skilled in the art based on the total of the disclosures and technical concepts inclusive of the claims. For example, the display system may be organic EL in place of LCD.

### REFERENCE SIGNS LIST

1, 2, 200 mobile electronic apparatus
10 screen
20 bottom cover
30, 30a key rubbers
40 LCD module
50, 51 casing sections
60, 61 cover sections
70 basement
80 flexible substrate
100, 101, 204 hollow sections
201 casing
202 elastic component
203 display part

## Claims

1. A mobile electronic apparatus, comprising:
a casing having an open part in a first surface thereof;
an elastic member arranged in the open part; and
a display part disposed adjacent to a second surface of the casing,
wherein the casing and the elastic member together delimit a hollow section, and
wherein in case an impact is applied to a third surface opposite to the second surface, the elastic member becomes deformed to follow deformation of the hollow section.

2. The mobile electronic apparatus according to claim 1, wherein,
the elastic member includes a protuberance contacted with a circuit configured to transform a user actuation into an electrical signal, the protuberance being disposed in the hollow section.

3. The mobile electronic apparatus according to claim 2, wherein,
the circuit is mounted on a substrate which is resilient and deformable, the circuit being disposed in the hollow section.

4. The mobile electronic apparatus according to any one of claims 1 to 3, wherein,
the third surface of the casing has a raised center portion.

5. The mobile electronic apparatus according to any one of claims 1 to 4, wherein,
the display part includes a screen or a substrate on which to display a picture image.

6. The mobile electronic apparatus according to any one of claims 1 to 5, wherein,
the display part is an LCD module.
